(19) Europäisches Patentamt
European Patent Office
Office européen des brevets

(11) EP 4 598 044 A1

(12) EUROPEAN PATENT APPLICATION
published in accordance with Art. 153(4) EPC

(43) Date of publication:
**06.08.2025 Bulletin 2025/32**

(21) Application number: **22961105.8**

(22) Date of filing: **25.10.2022**

(51) International Patent Classification (IPC):
***H04N 25/74*** *(2023.01)* ***H01L 31/107*** *(2006.01)*
***H01L 31/02*** *(2006.01)*

(52) Cooperative Patent Classification (CPC):
**H04N 25/773; H04N 25/74; H10F 30/225; H10F 77/00**

(86) International application number:
**PCT/KR2022/016336**

(87) International publication number:
**WO 2024/071506 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.09.2022 KR 20220122648**

(71) Applicant: **XO Semiconductor Inc.**
**Chuncheon-si, Gangwon-do 24329 (KR)**

(72) Inventors:
- **CHAE, Youngcheol**
  **Seoul 06276 (KR)**
- **PARK, Byungchoul**
  **Seoul 06298 (KR)**

(74) Representative: **Jung, Minkyu**
**Wuesthoff & Wuesthoff**
**Patentanwälte und Rechtsanwalt PartG mbB**
**Schweigerstraße 2**
**81541 München (DE)**

# (54) SINGLE-PHOTON AVALANCHE DIODE-BASED IMAGE SENSOR AND METHOD FOR DRIVING SAME

(57) A single-photon avalanche diode-based image sensor according to one embodiment of the present disclosure comprises: a single photon avalanche diode (SPAD) that generates a plurality of pulses corresponding to each of a plurality of photons received during a predetermined exposure time; a front-end circuit that receives a set of pulses, from among the plurality of pulses, received during a portion of the time of the exposure time; and a counter that counts the number of pulses in the set of pulses, wherein an end point of a portion of the time may be based on an overflow time point of the counter that counts the number of pulses in the set of pulses.

[FIG. 1]

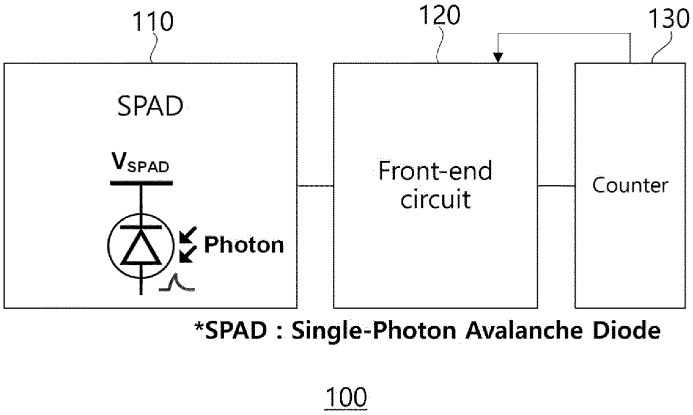




Processed by Luminess, 75001 PARIS (FR)

## Description

### Technical Field

The present disclosure relates to a single-photon avalanche diode-based image sensor and a method for driving the same.

The present disclosure is derived from the research conducted as part of Pan-Ministry Full-Cycle Medical Device Research and Development Project (Project Identification Number: 1711138024, Sub-Project Identification Number: RS-2020-KD000048, Research Project Name: Development of a 20 x 20 cm Large-Area Hybrid X-ray Video Detector Based on Global Shutter (Stage 2/2)(1/2), Organizer: Rayence Corporation, Research Period: 2022.03.01 ~ 2022.12.31) - Pan-Ministry Full-Cycle Medical Device Research and Development Project -Pan-Ministry - Other government agencies - Government in Pan-Ministry Full-Cycle Medical Device Research and Development Project Team. Meanwhile, the Korean government has no property interest in any aspect of the present disclosure.

### Background Art

A single-photon avalanche diode (SPAD) is a sensing technology that detects a very small light signal at the photon level. In particular, the single-photon avalanche diode uses an avalanche multiplication that amplifies a single incident photon, such that it has very high sensitivity and is very easy to photograph in dark places.

Meanwhile, in such a single-photon avalanche diode, an operation of counting trigger pulses generated by photons is required. However, when a counter with a large number of bits is used in order to count a large number of photons, the size of the circuit increases, resulting in a problem of increasing power consumption.

### Disclosure

### Technical Problem

In order to solve the problem described above, the present disclosure provides a single-photon avalanche diode-based image sensor that reduces power consumption in a way of estimating the number of total pulses (i.e., total photons) by using an overflow time point of a counter.

### Technical Solution

According to an exemplary embodiment of the present disclosure, a single-photon avalanche diode-based image sensor includes a single-photon avalanche diode (SPAD) configured to generate a plurality of pulses corresponding to each of a plurality of photons received during a predetermined exposure time, a front-end circuit configured to receive a set of pulses, which are received during a portion of time within the exposure time, among the plurality of pulses, and a counter configured to count the number of the pulses in the set of the pulses, wherein an end point of the portion of time is based on an overflow time point of the counter for counting the number of the pulses in the set of the pulses.

According to an exemplary embodiment, the counter may count the number of a plurality of clock pulses obtained through the front-end circuit during the exposure time after the overflow time point.

According to an exemplary embodiment, the time points of each of the plurality of clock pulses with respect to the exposure time may be configured to include at least one shape of a log function, a linear function, or a square root function.

According to an exemplary embodiment, the single-photon avalanche diode-based image sensor may further include a global clock for providing a plurality of clock pulses to the front-end circuit after the overflow time point.

According to an exemplary embodiment, the number of total clock pulses generated by the global clock during the exposure time may be configured to be the same as the number of the pulses in the set of the pulses received during the portion of time.

According to an exemplary embodiment, the single-photon avalanche diode-based image sensor may further include a processor configured to calculate a total number of a plurality of photons received in the single-photon avalanche diode during the exposure time by using a first clock pulse generated by the global clock before the overflow time point and a second clock pulse generated by the global clock after the overflow time point.

According to an exemplary embodiment, the processor may calculate the total number by using a lookup table related to the global clock.

According to an exemplary embodiment, in the single-photon avalanche diode-based image sensor, the counter may include a counter of N bits, wherein a value of one bit of the N bits is related to the overflow time point and the remaining plurality of bits other than the one bit of the N bits are related to a value obtained by counting the plurality of pulses.

According to another exemplary embodiment of the present disclosure, a method of driving a single-photon avalanche diode-based image sensor includes receiving a plurality of photons during at least a portion of time of a predetermined exposure time by a single-photon avalanche diode, generating a plurality of pulses corresponding to each of the plurality of photons by the single-photon avalanche diode, receiving the plurality of pulses by a front-end circuit, and counting the plurality of pulses by a counter, wherein an end point of at least the portion of time is configured to be based on an overflow time point of the counter for counting the plurality of pulses.

According to another exemplary embodiment of the present disclosure, provided may be a computer-readable, non-transitory recording medium where a program for executing a method for driving a single-photon avalanche diode-based image sensor is recorded.

## Advantageous Effects

According to some exemplary embodiments of the present disclosure, the power consumed by a counter may be significantly reduced through a way of counting only some of total photons received in a single-photon avalanche diode and estimating the total number of photons by utilizing an overflow time point of the counter.

## Description of Drawings

FIG. 1 is a view showing a configuration of a single-photon avalanche diode-based image sensor according to an exemplary embodiment of the present disclosure.

FIG. 2 is a graph illustrating a method of calculating the total number of photons received in a single-photon avalanche diode-based image sensor according to an exemplary embodiment of the present disclosure.

FIG. 3 is a graph showing clock pulses of a global clock arranged to provide clock pulse(s) to a front-end circuit according to an exemplary embodiment of the present disclosure.

## Mode for Invention

Hereinafter, detailed contents for practicing the present disclosure will be described in detail with reference to the accompanying drawings. However, detailed descriptions of well-known functions or configurations will be omitted in the following description when there is a risk of unnecessarily obscuring the gist of the present disclosure.

In the accompanying drawings, the same reference numerals are assigned to identical or corresponding components. In addition, duplicate descriptions of identical or corresponding components may be omitted in the explanation of the following exemplary embodiments. However, even when the description of the components is omitted, it is not intended that such components are not included in any exemplary embodiment.

The advantages and features of the disclosed exemplary embodiments and the methods for achieving them, will become apparent with reference to the exemplary embodiments described below along with the accompanying drawings. However, the present disclosure is not limited to the exemplary embodiments disclosed below and may be implemented in various forms different from each other, and the present exemplary embodiments may be only provided to make the present disclosure complete and to fully inform those skilled in the art of the scope of the disclosure.

Terms used in the present specification will be briefly described, and exemplary embodiments disclosed herein will be described in detail. The terms used in this specification are selected from as general terms currently widely used as possible in consideration of functions of the present disclosure, but may vary depending on the intention of engineers working in the relevant field, precedents, the emergence of new technologies, and the like. In addition, in certain cases, there may be terms arbitrarily selected by the applicant, in which case the meaning thereof will be described in detail in the corresponding description of the disclosure. Therefore, the terms used in the present disclosure should be defined on the basis of the meanings of the terms and the overall contents of the present disclosure, rather than simply the names of the terms.

Singular expressions in the present specification may include plural expressions unless the context clearly specifies that they are singular. In addition, plural expressions may include singular expressions unless the context clearly specifies that they are plural. When a part in the whole specification is said to "include" a component, this may mean that other components may be further included rather than excluding other components unless specifically stated to the contrary.

FIG. 1 is a view showing a configuration of a single-photon avalanche diode-based image sensor 100 according to an exemplary embodiment of the present disclosure. Simply, the image sensor 100 may generate an image in a way of receiving a plurality of photons from the outside and counting the number of a plurality of received photons. In this case, the image sensor 100 may consume a considerable amount of power to count the photons(s). To this end, the present disclosure may provide the image sensor 100 that reduces power consumption in a way of counting photons only up to a predetermined number and estimating the total number of received photons by using information on a time point when the corresponding counting ends. As shown, the image sensor 100 may include at least one of a single-photon avalanche diode 110, a front-end circuit 120, and a counter 130.

The single-photon avalanche diode 110 may receive the plurality of photons from the outside and may generate a plurality of pulses corresponding to each of the plurality of received photons. For example, when the single-photon avalanche diode 110 receives N photons (herein, N is a natural number), the single-photon avalanche diode 110 may generate N pulses. Then, the plurality of generated pulses may be transmitted to the front-end circuit.

The single-photon avalanche diode 110 may receive the plurality of photons from the outside during a predetermined exposure time and may generate the plurality of pulses corresponding to each of the plurality of received photons. For example, when the single-photon avalanche diode 110 receives N photons (herein, N is a natural number) from 0 [ms] to 16 [ms], the single-photon avalanche diode 110 may generate N pulses. Then, at least some of the plurality of generated pulses may be transmitted to the front-end circuit.

The front-end circuit 120 may receive the plurality of pulses generated by the single-photon avalanche diode 110. In this case, the plurality of pulses may refer to the plurality of pulses received in the single-photon avalanche diode 110 during the exposure time. For example, the front-end circuit 120 may receive N pulses from the single-photon avalanche diode 110 when the single-photon avalanche diode 110 receives N photons (herein, N is a natural number) from 0 [ms] to 16 [ms]. Additionally or alternatively, the front-end circuit 120 may receive at least some of the plurality of pulses generated by the single-photon avalanche diode 110. For example, the front-end circuit 120 may receive NOF pulses (herein, NOF < N) received from 0 [ms] to TOF [ms] (herein, TOF < 16) when the single-photon avalanche diode 110 receives N photons (herein, N is a natural number) from 0 [ms] to 16 [ms]. In another example, the front-end circuit 120 may receive NOF pulses (herein, NOF < N) received from TOF1 [ms] to TOF2 [ms] (herein, 0 < TOF1 < TOF2 <= 16) when the single-photon avalanche diode 110 receives N photons (herein, N is a natural number) from 0 [ms] to 16 [ms].

The front-end circuit 120 may receive a plurality of clock pulses generated in an external device (e.g., a global clock). In this case, a plurality of clock pulses may refer to a plurality of clock pulses generated during the exposure time. For example, the front-end circuit 120 may receive M clock pulses from 0 [ms] to 16 [ms]. Additionally or alternatively, the front-end circuit 120 may receive the plurality of clock pulses generated during a portion of time of the total exposure time. For example, the front-end circuit 120 may receive clock pulses generated between TOF [ms] and 16 [ms] during the exposure time from 0 [ms] to 16 [ms]. In another example, the front-end circuit 120 may receive clock pulses generated between 0 [ms] and TOF [ms] during the exposure time from 0 [ms] to 16 [ms].

The front-end circuit 120 may start receiving the plurality of clock pulses generated in an external device in response to a signal received from the counter 130. In this case, the signal received from the counter 130 may refer to a signal generated in response to the overflow of the counter 130. More specifically, the signal received from the counter 130 may refer to a signal transmitted to the front-end circuit 120 in response to the overflow of the counter 130 counting the plurality of pulses received from the single-photon avalanche diode 110 through the front-end circuit 120. For example, when the exposure time is from 0 [ms] to 16 [ms], the counter 130 of N bits may use the number of bits from 0 to N-1, and may overflow after counting 2(N-1) pulses received from the single-photon avalanche diode 110 through the front-end circuit 120. In this case, a value indicating the overflow may be inputted to the remaining one bit, which is not used for counting among the N bits of the counter 130, in response to which the counter 130 can transmit a signal to the front-end circuit 120 at TOF [ms]. Then, in response to the signal received from the counter 130, the front-end circuit 120 may stop receiving pulses from the single-photon avalanche diode 110 and start receiving clock pulses from an external device. That is, the front-end circuit 120 may receive the plurality of pulses from the single-photon avalanche diode 110 until the time before TOF [ms] from 0 [ms] and may receive the plurality of clock pulses from the external device until 16 [ms] after TOF [ms].

The counter 130 may be capable of counting the number of pulse(s) inputted to the front-end circuit 120. For example, the counter 130 may count the number of pulses of the plurality of pulses inputted to the front-end circuit 120 from the single-photon avalanche diode 110 until before TOF [ms] from 0 [ms]. As an additional or alternative example, the counter 130 may be capable of counting the number of clock pulses inputted to the front-end circuit 120 until 16 [ms] after TOF [ms].

Meanwhile, although not shown in FIG. 1, the image sensor 100 may further include a global clock (not shown) for generating the clock pulse described above. In this case, the total number of clock pulses generated by the global clock during the exposure time may be the same as the number of pulses counted until just before the counter 130 of N bits (in this case, only N-1 bits of the counter 130 are used for counting) overflows (that is, until the time before TOF [ms] in the example described above). That is, when the counter 130 of the N bits is used, the total number of clock pulses generated by the global clock during the exposure time may be set to 2(N-1) in advance. A detailed description thereof will be described later with reference to FIG. 3.

In addition, the image sensor 100 may be illustrated as including one single-photon avalanche diode 110 in FIG. 1 for convenience of description, but is not limited thereto. That is, the image sensor 100 may include a plurality of single-photon avalanche diodes. For example, the front-end circuit 120 may be connected to the plurality of single-photon avalanche diodes disposed in each of a plurality of pixels.

FIG. 2 is a graph 200 illustrating a method of calculating the total number of photons received in a single-photon avalanche diode-based image sensor (e.g., an image sensor 100) according to an exemplary embodiment of the present disclosure. Herein, it is assumed that the counter (e.g., the counter 130), which is prepared for counting pulses generated by the single-photon avalanche diode (e.g., the single-photon avalanche diode 110) and/or the global clock, is composed of N bits and only N-1 bits are used for counting. In addition, the TOF in FIG. 2 may indicate when the counter overflows as a result of counting the plurality of pulses received from the single-photon avalanche diode.

As described in FIG. 1, the counter may count only 2(N-1) pulses generated by the single-photon avalanche diode during the time between 0 and TOF in order to save power consumption. In this case, the time TEXP during which the image sensor is exposed to the light source may have a predetermined value, so the image sensor may calculate the total number of photons (NPH) received during the exposure time according to Equation 1 below. In this case, the power can be saved as much as counting photon(s) of NPH/NOF. The NOF may refer to the number of photons received by the image sensor from a time point when the image sensor starts to be exposed to the light source to a time point when the counter overflows. Meanwhile, in order to calculate the total number of photons (NPH) by using Equation 1, it may be necessary to first know the TOF indicating the time when the counter overflows. A method of estimating the TOF will be described later with reference to FIG. 3.

[Equation 1]

$$N_{PH} = N_{OF} * (T_{EXP}/T_{OF})$$

FIG. 3 is a graph 300 showing clock pulses of a global clock arranged to provide clock pulse(s) to a front-end circuit according to an exemplary embodiment of the present disclosure. Similarly, it is assumed that the counter (e.g., the counter 130), which is prepared for counting pulses generated by the single-photon avalanche diode (e.g., the single-photon avalanche diode 110) and/or the global clock, is composed of N bits and only N-1 bits are used for counting. In addition, each of the TOF and the TEXT may indicate the time when the counter overflows and the time when the single-photon avalanche diode is exposed to the light source like the TOF and the TEXP shown in FIG. 2.

As described in FIG. 1, the total number (M) of clock pulses generated during the exposure time may be set to be same as the number (i.e., 2(N-1)) of the plurality of pulses generated by the single-photon avalanche diode between 0 and TOF. In addition, the time points of each of the total clock pulses may be set to include at least one function among a log function, a linear function, and a square root function with respect to the exposure time. For example, the clock pulses between 0 and TOF may be provided in the form of a linear function, and the clock pulses between the TOF and the TEXP may be provided in the form of a log function. That is, each time point of the total clock pulses may have a predetermined value based on the shape of the selected function. Accordingly, the time point (Tn) of the clock pulse occurring latest before TOF can be calculated by using the order (herein, n+1) and time point (Tn+1) of the clock pulse occurring earliest after TOF. In this case, the overflow of the counter may occur at the time point between Tn and Tn+1, so the TOF may be estimated to be an arbitrary value between NOF*(TEXP/Tn) and NOF*(TEXP/Tn+1) as shown in Equation 2 below.

[Equation 2]

$$N_{PH} = N_{OF} * \left(\frac{T_{EXP}}{T_n}\right) \sim N_{OF} * \left(\frac{T_{EXP}}{T_{n+1}}\right)$$

The previous description of the present disclosure is provided to enable those skilled in the art to practice or use the present disclosure. Various modifications of the present disclosure will be easily apparent to those skilled in the art, and the general principles defined herein may be applied to various variations without departing from the purpose or scope of the present disclosure. Accordingly, the present disclosure may not be intended to be limited to the examples described herein, but may be intended to be assigned the widest scope consistent with the principles and novel features disclosed herein.

The present disclosure in the present specification has been described in connection with some exemplary embodiments, but it should be understood that various modifications and variations can be made without departing from the scope of the present disclosure understood by those skilled in the art to which the present disclosure pertains. In addition, such variations and modifications should be considered to fall within the scope of the patent claims attached to the present specification.

**Claims**

1. A single-photon avalanche diode-based image sensor, the sensor comprising:

    a single-photon avalanche diode (SPAD) configured to generate a plurality of pulses corresponding to each of a plurality of photons received during a predetermined exposure time;
    a front-end circuit configured to receive a set of pulses, which are received during a portion of time within the exposure time, among the plurality of pulses; and
    a counter configured to count the number of the pulses in the set of the pulses,
    wherein an end point of the portion of time is based on an overflow time point of the counter for counting the number of the pulses in the set of the pulses.

2. The sensor of claim 1, wherein the counter counts the number of a plurality of clock pulses obtained through the front-end circuit during the exposure time after the overflow time point.

3. The sensor of claim 2, wherein the time points of each of the plurality of clock pulses with respect to the exposure time is configured to include at least one shape of a log function, a linear function, or a square root function.

4. The sensor of claim 1, further comprising:
a global clock configured to provide a plurality of clock pulses to the front-end circuit after the overflow time point.

5. The sensor of claim 4, wherein the number of total clock pulses generated by the global clock during the exposure time is configured to be the same as the number of the pulses in the set of the pulses received during the portion of time.

6. The sensor of claim 4, further comprising:
a processor configured to calculate a total number of a plurality of photons received in the single-photon avalanche diode during the exposure time by using a first clock pulse generated by the global clock before the overflow time point and a second clock pulse generated by the global clock after the overflow time point.

7. The sensor of claim 6, wherein the processor calculates the total number by using a lookup table related to the global clock.

8. The sensor of claim 1, wherein the counter comprises a counter of N bits,
wherein a value of one bit of the N bits is related to the overflow time point and the remaining plurality of bits other than the one bit of the N bits are related to a value obtained by counting the plurality of pulses.

9. A method for driving a single-photon avalanche diode-based image sensor, the method comprising:

    receiving a plurality of photons during at least a portion of time of a predetermined exposure time by a single-photon avalanche diode;
    generating a plurality of pulses corresponding to each of the plurality of photons by the single-photon avalanche diode;
    receiving the plurality of pulses by a front-end circuit; and
    counting the plurality of pulses by a counter,
    wherein an end point of at least the portion of time is configured to be based on an overflow time point of the counter for counting the plurality of pulses.

10. A computer-readable, non-transitory recording medium where a program for executing the method for driving the single-photon avalanche diode-based image sensor according to claim 9 is recorded.

[FIG. 1]

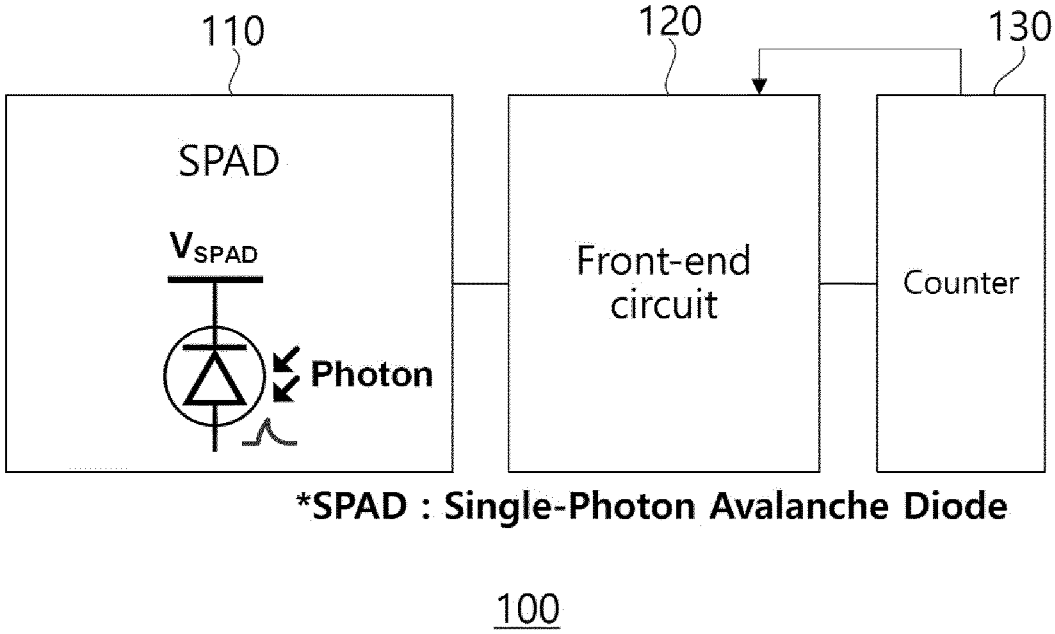
110
120
130
SPAD
VSPAD
Photon
Front-end circuit
Counter
*SPAD : Single-Photon Avalanche Diode
100

[FIG. 2]

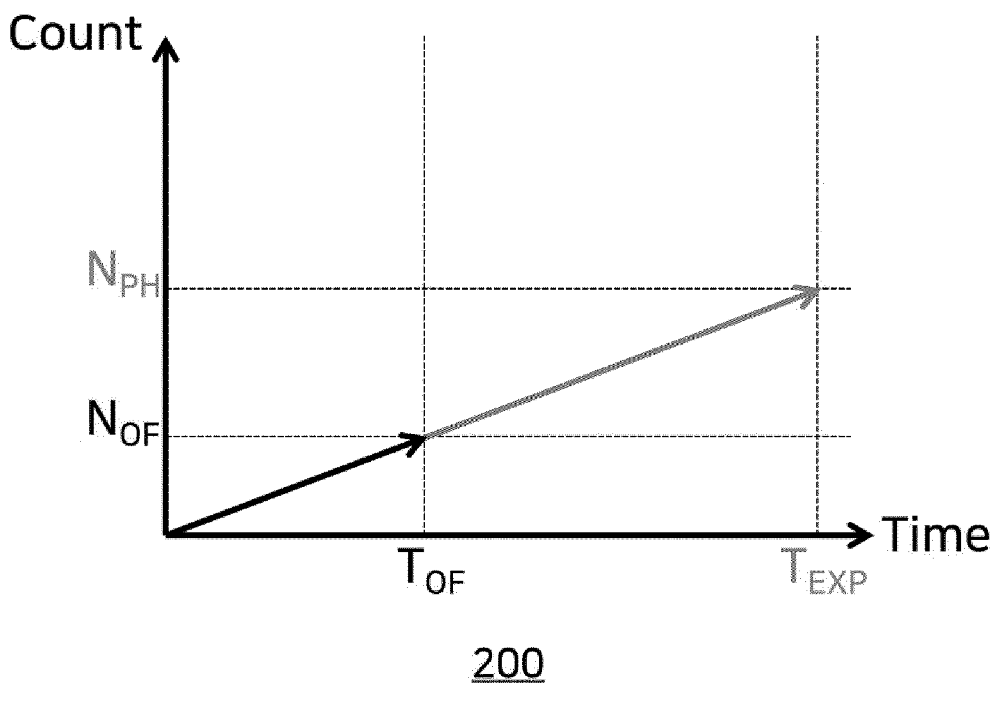

[FIG. 3]

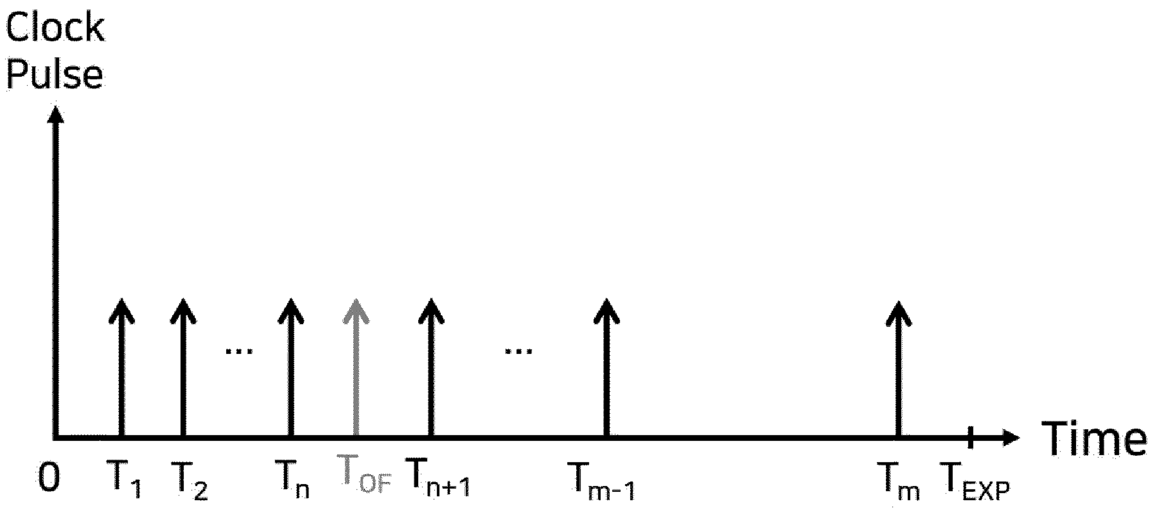

## INTERNATIONAL SEARCH REPORT

International application No.
**PCT/KR2022/016336**

### A. CLASSIFICATION OF SUBJECT MATTER

**H04N 25/74**(2023.01)i; **H01L 31/107**(2006.01)i; **H01L 31/02**(2006.01)i

According to International Patent Classification (IPC) or to both national classification and IPC

### B. FIELDS SEARCHED

Minimum documentation searched (classification system followed by classification symbols)

H04N 25/74(2023.01); G01J 1/02(2006.01); G01J 1/42(2006.01); G01J 1/44(2006.01); G01S 17/10(2006.01); G01S 17/42(2006.01); H01L 31/107(2006.01); H04N 5/3745(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 단광자 애벌런치 다이오드(Single Photon Avalanche Diode, SPAD), 카운터(counter), 오버플로우(overflow), 클락(clock), 펄스(pulse), 프론트엔드(front-end)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2022-112700 A (CANON INC.) 03 August 2022 (2022-08-03)<br>See paragraphs [0006], [0021] and [0025]-[0027]; and figure 4. | 1-2,8-10<br>3-7 |
| A | JP 2019-193043 A (CANON INC.) 31 October 2019 (2019-10-31)<br>See paragraphs [0013]-[0022]; claim 1; and figure 1. | 1-10 |
| A | JP 2021-090230 A (CANON INC.) 10 June 2021 (2021-06-10)<br>See paragraphs [0021]-[0025]; claim 1; and figure 2. | 1-10 |
| A | WO 2019-150785 A1 (SONY SEMICONDUCTOR SOLUTIONS CORPORATION) 08 August 2019 (2019-08-08)<br>See paragraphs [0040]-[0052]; and figure 7. | 1-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 June 2023** | **22 June 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208**<br>Facsimile No. **+82-42-481-8578** | Telephone No. |

Form PCT/ISA/210 (second sheet) (July 2022)

**INTERNATIONAL SEARCH REPORT**

International application No.
**PCT/KR2022/016336**

**C. DOCUMENTS CONSIDERED TO BE RELEVANT**

| Category* | Citation of document, with indication, where appropriate, of the relevant passages | Relevant to claim No. |
|---|---|---|
| A | KR 10-2019-0131050 A (OUSTER, INC.) 25 November 2019 (2019-11-25) See paragraphs [0038]-[0071]; and figures 2-5. | 1-10 |

Form PCT/ISA/210 (second sheet) (July 2022)

**INTERNATIONAL SEARCH REPORT**
**Information on patent family members**

International application No.
**PCT/KR2022/016336**

| Patent document cited in search report | Publication date (day/month/year) | Patent family member(s) | Publication date (day/month/year) |
|---|---|---|---|
| JP 2022-112700 A | 03 August 2022 | US 2022-0236420 A1 | 28 July 2022 |
| JP 2019-193043 A | 31 October 2019 | CN 110392183 A | 29 October 2019 |
| | | CN 110392183 B | 29 March 2022 |
| | | EP 3562147 A1 | 30 October 2019 |
| | | JP 7193926 B2 | 21 December 2022 |
| | | US 11076108 B2 | 27 July 2021 |
| | | US 2019-0327424 A1 | 24 October 2019 |
| JP 2021-090230 A | 10 June 2021 | JP 7265828 B2 | 27 April 2023 |
| WO 2019-150785 A1 | 08 August 2019 | CN 111434105 A | 17 July 2020 |
| | | CN 111434105 B | 12 May 2023 |
| | | EP 3748316 A1 | 09 December 2020 |
| | | EP 3748316 B1 | 20 April 2022 |
| | | US 11330202 B2 | 10 May 2022 |
| | | US 2021-0051279 A1 | 18 February 2021 |
| KR 10-2019-0131050 A | 25 November 2019 | CN 110537124 A | 03 December 2019 |
| | | CN 110537124 B | 07 December 2021 |
| | | CN 114114209 A | 01 March 2022 |
| | | EP 3589990 A1 | 08 January 2020 |
| | | EP 3589990 A4 | 20 January 2021 |
| | | JP 2020-512544 A | 23 April 2020 |
| | | JP 2022-172248 A | 15 November 2022 |
| | | JP 7134988 B2 | 12 September 2022 |
| | | TW 201835603 A | 01 October 2018 |
| | | TW I765977 B | 01 June 2022 |
| | | US 10317529 B2 | 11 June 2019 |
| | | US 10830888 B2 | 10 November 2020 |
| | | US 10884126 B2 | 05 January 2021 |
| | | US 2018-0259645 A1 | 13 September 2018 |
| | | US 2018-0299552 A1 | 18 October 2018 |
| | | WO 2018-160886 A1 | 07 September 2018 |

Form PCT/ISA/210 (patent family annex) (July 2022)